(19) Europäisches Patentamt
European Patent Office
Office européen des brevets

(11) Publication number: 0 068 902
A1

# (12) EUROPEAN PATENT APPLICATION

(21) Application number: 82303438.4

(22) Date of filing: 30.06.82

(51) Int. Cl.³: G 03 F 7/08

(30) Priority: 30.06.81 JP 100625/81

(43) Date of publication of application: 05.01.83
Bulletin 83/1

(84) Designated Contracting States: DE FR GB

(71) Applicant: KONISHIROKU PHOTO INDUSTRY CO. LTD.,
No. 26-2, Nishishinjuku 1-chome Shinjuku-ku, Tokyo (JP)

(72) Inventor: Oya, Yukuo, 2-5-19 Owada-cho, Hachioji-shi Tokyo (JP)
Inventor: Kita, Noriyasu, 2-52-5 Ominami, Misashimurayama-shi Tokyo (JP)
Inventor: Goto, Kiyoshi, 1210-109 Kunugida-cho, Hachioji-shi Tokyo (JP)

(74) Representative: Ellis-Jones, Patrick George Armine et al, J.A. KEMP & CO. 14 South Square Gray's Inn, London WC1R 5EU (GB)

## (54) Water-developable lithographic printing plate material.

(57) A water-developable lithographic printing plate material is described comprising a support characterised by comprising on the support a photosensitive layer containing an oil-soluble diazo resin and a non-photosensitive resin having a moisture sorption ratio from 5 to 20% at 80% relative humidity.

EP 0 068 902 A1

# WATER-DEVELOPABLE LITHOGRAPHIC PRINTING PLATE MATERIAL

The present invention relates to a lithographic printing plate material, and more particularly to a water-developable lithographic printing plate material comprising a diazo resin.

There are known water-developable lithographic printing plate materials having a composite comprising a water-soluble macromolecular compound and a water-soluble diazo resin. Photosensitive layers obtained by coating said composite are water-soluble; therefore careful attention has to be paid to handling them so they do not come into contact with a dampish hand, for example; accordingly handling efficiency is seriously reduced. It has also been impossible to preserve them for a long period of time, because they are liable to be affected by moisture in the air. Further, they have less affinity for printing ink and possess very poor printability, because the photohardened coat thereof is hydrophilic and fragile.

In order to solve the above-mentioned problems, an attempt has been made to coat a lipophilic resin on a water-soluble photosensitive layer, with the surface of the printing plate material rendered hydrophobic. However, the said plate material has a double-layer system, so that its preparation is complicated, with a consequent unavoidable

high cost, and the resolution power is also poor.

Some attempts have also been made using a single-layer system. For example, in Japanese Patent Publication Open to Public Inspection (hereinafter referred to as O P I) No 2520/1977, there is disclosed a printing plate material comprising an aqueous emulsion of lipophilic resin and a water-soluble diazo resin; however moisture is liable to affect the plate material and the preservability and the stability thereof is poor. Also in O P I No 120028/1980, for example, there is disclosed a printing plate material comprising a homogeneous mixture of a lipophilic film forming resin, a free-radical polymerisable unsaturated compound, a lipophilic diazo compound, a water-soluble resin and an initiator. However, oxygen in the air is liable to affect said plate material and the preservability and the stability thereof is poor. Again, in O P I No 59433/1980, there is disclosed a printing plate material comprising an epoxy resin and a lipophilic diazo resin. However the preservability and the stability thereof is poor because of the reaction of said epoxy resin during storage in the dark. Thus, up to the present time there has not yet been devised a lithographic printing plate material which can be developed with water, the resolving power of which is excellent, which is unaffected by oxygen, and the preservability and stability of which are also excellent.

The present invention is intended to solve these problems.

According to this invention there is provided a lithographic printing plate material possessing excellent resolving power, preservability and stability, water-resisting properties and lipophilic properties, which prints well and which possesses excellent water-developability, and is substantially unaffected by oxygen.

The lithographic printing plate material of this invention comprises a photosensitive layer containing an oil-soluble diazo resin and a non-photosensitive resin having a moisture sorption ratio within the range of 5 - 20% at 80% of the relative humidity on a support.

The oil-soluble diazo resin to be used in the invention is preferably an oil-soluble condensate of an aromatic diazonium salt and an active carbonyl containing compound such as formaldehyde or acetaldehyde, inter alia a condensate of said salt and formaldehyde. Preferred oil-soluble resins include organic solvent-soluble diazo resin inorganic acid salts such as a reaction product which is a condensate of, for example, a p-diazo diphenylamine salt and formaldehyde or acetaldehyde with an inorganic acid salt such as a hexafluorophosphate, a tetrafluoroborate, a perchlorate or a periodate; or a diazo resin organic acid salt such as a reaction product, as described in US Patent No 3 300 309, which is produced by

the reaction of the above-mentioned condensate with an organic acid or a salt thereof, for example a sulfonic acid such as p-toluene sulfonic acid or a salt thereof, a phosphinic acid such as benzene phosphinic acid or a salt thereof, a hydroxyl group-containing compound such as 2-hydroxy-4-methoxy-benzophenone-5-sulfonic acid or a salt thereof.

Preferred non-photosensitive resins which can be used in this invention include [A] a cellulose derivative or a polyvinyl alcohol derivative, [B] a homopolymer of acrylic acid or methacrylic acid, or a copolymer of said acid with one or more copolymerisable monomers, [C] a homopolymer of acrylamide monomers, methacrylamide monomers, acrylic ester monomers having a hydroxyl group or methacrylic ester monomers having a hydroxyl group, or a copolymer of said monomers with one or more copolymerisable monomers.

Typical examples of the cellulose derivatives to be used in the invention are those in which at least one of the hydrogen atoms in the hydroxyl group in cellulose is substituted by an alkyl, hydroxyalkyl and/or acyl group. Specific examples of said cellulose derivatives include hydroxymethyl cellulose, hydroxyethyl cellulose, hydroxypropyl cellulose, hydroxypropylmethyl cellulose phthalate, hydroxypropylmethyl cellulose hexahydrophthalate, methyl cellulose, ethyl cellulose and propyl cellulose.

Concrete examples of polyvinyl alcohol derivatives to be used in the invention are those having a saponification value of 20 - 50%, specifically those of formula:

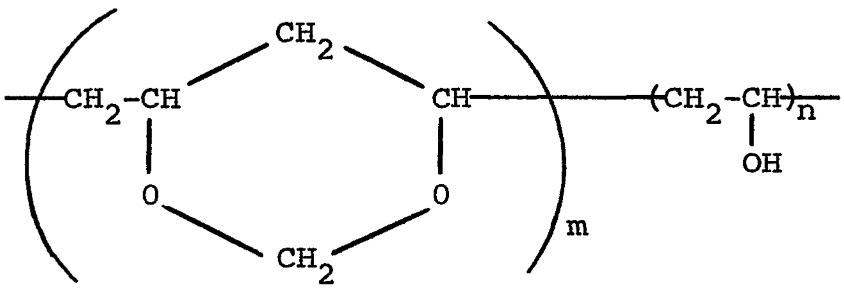

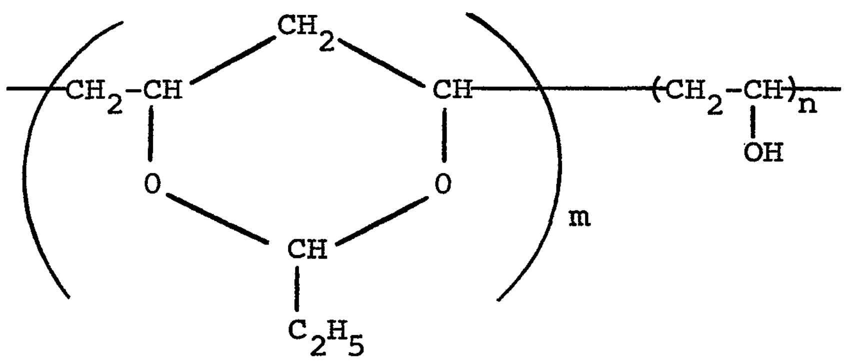

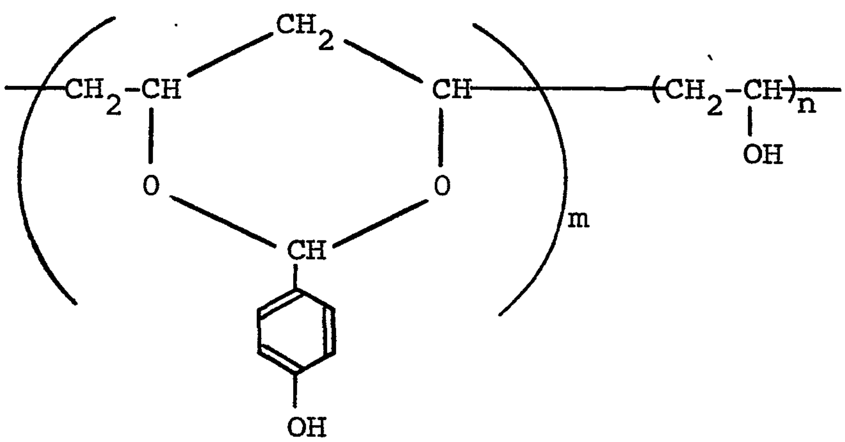

and

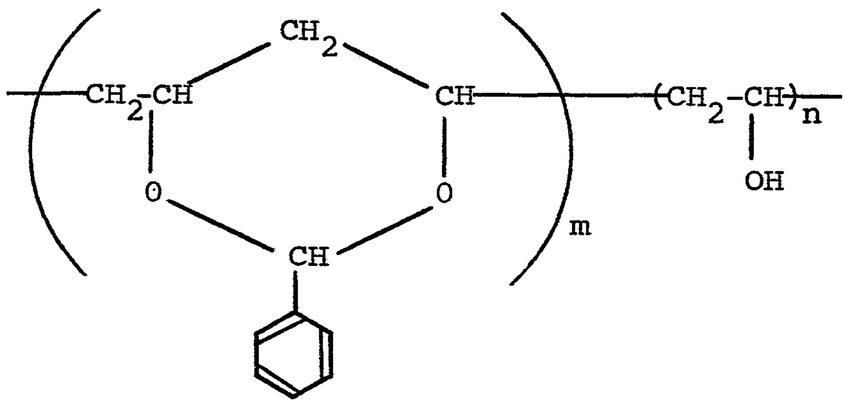

m and n being such that the molecular weight is 1 000 to 100 000.

Examples of suitable acrylamides, methacrylamides, acrylic esters having a hydroxyl group, and methacrylic esters having a hydroxyl group include those having the following General Formula [I]:

Formula [I]

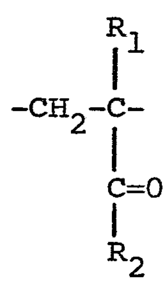

$R_1$ : H, $CH_3$

$R_2$ : 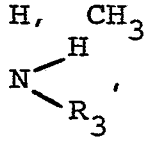 , $-OR_4$

$R_3$ : H, 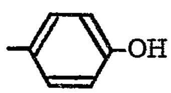

$R_4$ : $-(CH_2)_m-OH$, $-(CH_2CH_2O)_n-H$

m, n: 1 - 8

Monomers which give the monomer units of Formula [I] include acrylamide, p-hydroxyphenyl methacrylamide, hydroxymethyl methacrylate, hydroxyethyl methacrylate and hydroxypropyl methacrylate.

In the invention, copolymers containing an acrylic acid unit, methacrylic acid unit, an acrylamide unit, a methacrylamide unit, an acrylester unit having a hydroxyl group or a methacryl ester having a hydroxyl group as the monomer unit thereof, may contain at least one kind of said monomer units.

The proportion of said monomer units in the copolymer is preferably not less than 30% by weight.

Concrete examples of the homopolymers of the copolymers containing at least one kind of the aforesaid units are given as follows, the weight percentages of the monomer units being put in parentheses:

[1] Polyhydroxyethyl methacrylate,

[2] Poly-p-hydroxyphenyl methacrylamide,

[3] Copolymer of hydroxyethyl methacrylate/butyl acrylate/styrene (40:15:35)

[4] Copolymer of hydroxyethyl methacrylate/butyl acrylate/acrylic acid/styrene (40:25:10:25)

[5] Copolymer of p-hydroxyphenyl methacrylamide/acrylonitrile/butyl acrylate/acrylic acid (20:20:40:20)

[6] Copolymer of butyl methacrylate/acrylic acid/styrene (25:50:25)

[7] Copolymer of methyl methacrylate/butyl acrylate/acrylic acid/styrene (10:10:50:30)

[8] Copolymer of butyl acrylate/acrylic acid/hydroxyethyl acrylate (30:30:40)

[9] Copolymer of butyl acrylate/methacrylic acid (50:50)

The moisture sorption ratio of the non-photosensitive resin to be used in the invention is within the range of 5 - 20% at the relative humidity of 80%. In the invention, if the moisture sorption ratio exceeds 20%, then the water-repellency ink-acceptability and the preservability and stability of the printing plate material are reduced. On the other hand, if the moisture sorption ratio thereof is not more than 5%, then the developability of the printing plate material deteriorates considerably The said moisture sorption ratio can be measured in accordance with the weighing bottle method as described in "a Handbook of Materials and Moisture" p. 177, edited by The Society of Polymer Science, Japan, Published by The Kyoritsu Publishing Co., 1968.

The lithographic printing plate materials of the invention

do not contain any significant quantity of water-soluble resin, so that they are not affected by traces of moisture and they can be developed with water in spite of the fact that no significant quantity of water-soluble compound is contained therein. These facts could not have been predicted.

Although we do not wish to be bound by any particular theory, we infer said facts from the phenomenon that when the development is carried out with water, a layer in the area exposed to light is not affected by water because a mesh-like structure is formed which hardens solidly in said area, while in the area unexposed to light water permeates into said non-photosensitive resin thereby lowering its Young's modulus so that it softens; thus the printing plate material is developed by applying a physical force thereonto.

As for the supports of the printing plate material, a plastics film (e.g. cellulose diacetate, cellulose triacetate, polyethylene terephthalate and polystyrene), an aluminium plate, a zinc plate, a copper plate or a chrome-plated iron plate, for example, can be used.

When using a support having a metallic surface, and an aluminium surface in particular, it is preferable to give it a surface treatment, for example a sandblast treatment, dipping it in an aqueous solution such as a sodium silicate, potassium fluorozirconate or phosphate solution, and/or an anodic oxidation treatment. An aluminium plate

which has been treated by sandblast and then treated by dipping into an aqueous solution of sodium silicate as described in US Patent No 2 714 066 or an aluminium plate which is anodized and then dipped into an aqueous solution of an alkaline metal silicate as described in Japanese Patent Examined Publication No 5125/1972 are particularly suitable for such supports.

The amount of the aforesaid photosensitive layer to be provided on the support depends upon the purpose of using the printing plate material of the invention, but it is suitably 0.5 - 100 $mg/dm^2$ and more preferably 5.0 - 50 $mg/dm^2$.

It is preferable that the amount of oil-soluble diazo resin added is 1 - 20% by weight of the gross weight of the photosensitive layer. The amount of the non-photosensitive resin is preferably 40 - 90% by weight of the gross weight.

Of methods for coating the photosensitive layer, there may be mentioned dip-coating, roller-coating, revolving coating, air-knife coating and spray-coating. The density of the coating solutions is determined in accordance with coating method, coating conditions, amount to be coated and the like.

With the purpose of improving upon the so-called "clearing properties", a water-soluble compound layer or a water-soluble photosensitive layer may be included as a

subbing layer between the support and the photosensitive layer; however, if the amount of said subbing layer coated is too great, the preservability, stability and resolving power can be affected adversely. The amount of said subbing layer is preferably not more than 80% by weight of the amount of said photosensitive layer.

More preferred lithographic printing plate materials of this invention comprise a photosensitive layer containing an oil-soluble diazo resin and said non-photosensitive resin directly on the support.

A filler is desirably included in the coating solution for a photosensitive layer. We have found that the water-developability can be improved by adding a filler into the photosensitive layer. The reason for this is not clear but it is believed to be due to the fact that an unexposed area in the photosensitive layer is softened more, when developed with water, because the intermolecular force between the resins of the photosensitive layer is weakened by the addition of said filler.

Preferred fillers are those capable of transmitting an activated ray of light and of being inactive against an oil-soluble diazo resin or a non-photosensitive resin. More specifically, suitable inorganic fillers include asbestos, alumina, attapulgite, kaolin clay, finely powdered silicic acid, diatomaceous earth, titanium oxide, silicon oxide, quartz powder and talc; other suitable fillers

include organic pigments of a phthalocyanine, a dioxazine or an anthraquinone dye; or a hydrophobic polymer dispersed in an organic solvent as described in Japanese Patent Publication Open to Public Inspection No 149 326/1980. The above-mentioned filler suitably has a grain diameter of 1 mμ - 100 μ, preferably 1 mμ - 10 μ. Also fillers or pigments which are dispersed in an organic solvent using the aforesaid non-photosensitive resin as a dispersion protector can be used.

The amount of said filler is generally 1 to 60% by weight of the gross weight of the photosensitive layer, preferably 3 to 45% by weight thereof.

In order to improve the ink receptivity, a polyalkyl acrylate such as polyethyl acrylate, polypropyl acrylate, polybutyl acrylate or polyoctyl acrylate, a polyalkyl methacrylate such as polyethyl methacrylate, polypropyl methacrylate, polybutyl methacrylate or polyoctyl methacrylate, a resin in which an alkyl phenol is condensed with formaldehyde (of which the alkyl group is, say, an ethyl, propyl, butyl or octyl group), for example, may be incorporated into the photosensitive layer to serve as an ink receptive ingredient. The amount added is adjusted so that the water-developability is not harmed in relation to the moisture sorption ratio of the non-photosensitive resin and the amount added.

The photosensitive layer used in this invention may contain an azide group-containing polymer, a photosensitive polymer having a crosslinkable group of the formula

$$-CH=\overset{\overset{R}{|}}{C}-CO- \quad \text{(R: hydrogen atom, cyano group, halogen atom)}$$

in a main chain or a side chain thereof.

The photosensitive layer can contain a variety of additives as occasion demands.

It is also possible to add an exposed image visualizer for visualizing an image exposed to light such as an acridine dye, cyanine dye, merocyanine dye, styryl dye or triphenyl methane dye; the aforesaid organic pigments of a phthalocyanine, dioxazine or anthraquinone dye; a combination of a leuco dye with an aromatic azide, carbonyl azide, sulfonyl azide or polyhalomethyl compound; a spiropyrane compound which changes color on exposure to light as described in Japanese Patent Examined Publication No 6413/1969, for example. The amount added depends on the degree of object visible image but is in the order of 1 - 5% by weight of the gross weight of the photosensitive layer. When using an organic pigment to serve as a filler, said exposed image visualizer is usually not required. Again, a stabilizer, a surface active agent, a plasticizer, a thickener or a levelling agent, for example, can also be added.

The photosensitive layer of this invention forms a hydrophobic resin image through water-development after image exposure to light.

The light source to be used for image exposure is one having a photosensitive wavelength which corresponds to those of the photosensitive layer; in general it has a wavelength from 300 nm to 450 nm. For example, a mercury lamp, a carbon-arc lamp, a xenon lamp or a metal halide lamp may be used.

The exposed area in the photosensitive layer is not removed when water-development is carried out, while the unexposed area is easily removed off when its surface is rubbed softly with an absorbent cotton or a sponge, for example, and thus a lipophilic and hydrophobic resin image is formed on the support.

The following Examples further illustrate the present invention. The moisture sorption ratio indicated was obtained at a relative humidity of 80%.

EXAMPLE 1

The surface of 3S aluminium plate (0.24 mm thick) was scoured by means of a nylon brush and pumice (400 mesh) suspension liquid, and was then washed with water, and then was etched with a 10% aqueous solution of sodium hydroxide at 50°C for twenty seconds. A desmat treatment was applied to the plate thus etched by dipping it in 30% nitric acid solution at room temperature for twenty seconds, and an anodizing treatment was further carried out using a sulfuric acid solution at 40°C, a voltage of 10V and a current density of $2A/dm^2$ for five minutes. Then, a sealing treatment

was applied by dipping it in a 5% sodium silicate aqueous solution for 5 minutes at 80°C. The graininess of the aluminium plate obtained was $R_z$=4.5 μ (DIN) and the coating obtained by anodizing treatment amounted to 15 mg/dm$^2$.

The following composition was coated on the aluminium plate mentioned above with a rotary coating machine; thereafter it was dried at 55°C for one hour, and a lithographic printing plate material was thus obtained. The amount of coating of thus obtained photosensitive layer was 27 mg/dm$^2$.

| | By wt |
|---|---|
| Hydroxypropyl methylcellulose phthalate (moisture sorption ratio: 8.3%) | 80 parts |
| Oil-soluble diazo resin (Hexafluoro phosphate salt of p-diazo diphenyl condensed with paraformaldehyde) | 10 parts |
| Copper phthalocyanine pigment dispersed in methyl cellosolve (ethylene glycol monomethyl ether) to make 10% solution | 100 parts |
| Methyl cellosolve | 810 parts |

A halftone dot original of 150 lines/inch was brought into close contact with the aforesaid lithographic printing plate material and exposed to the light of an "Idlefin 2000", a 2KW metal halide lamp, mfd. by Iwasaki Electric Works at a distance of one meter for 40 seconds, and thereafter dipped in water at about 18°C for one minute and then rubbed softly, to carry out the development.

As a result, an excellent printing plate was obtained in which the unexposed area had been removed and the halftone dots were reproduced from fidelity from 3% to 97%. This printing plate was set in a "Komori Sprint L-25B" offset printing machine and then printing was carried out using Ultra King printing ink, mfd. by Toyo Ink Co. As a result, not less than 50 000 excellent prints with a rich ink density were obtained without plate blinding, because the printing ink receptivity thereon was excellent.

## EXAMPLE 2

The following composition was coated in the same manner as in Example 1 on the same aluminium plate used in Example 1, and a lithographic printing plate material was obtained.

| [Photosensitive liquid] | By wt |
|---|---|
| Copolymer of styrene: methyl methacrylate: butyl acrylate: acrylic acid (30:10:20:40) (Moisture sorption ratio: 16%) | 52 parts |
| Oil-soluble diazo resin (The same as in Example 1) | 38 parts |
| Copper phthalocyanine pigment (The same as in Example 1) | 100 parts |
| Methyl cellosolve | 810 parts |

The coating of the photosensitive layer after drying was 28 $mg/dm^2$ by weight.

BAD ORIGINAL

Similar to the case of Example 1, exposure to light and the development were carried out; the plate was then set in a printing machine, and a number of excellent prints were obtained.

Separately, a lithographic printing plate material which had been coated and dried was kept for ten days at 55°C at a relative humidity of 3 - 4%, and then the exposure to light, development and printing were successively carried out. As a result, a number of excellent prints were obtained similar to those obtained with the printing plate which had not been kept.

CONTROL EXAMPLE 1

As indicated in Japanese Patent Publication Open to Public Inspection No. 120028/1980, a photosensitive liquid of the following composition containing a photopolymeric compound as the principal component was coated and dried in the similar manner to Example 1; a lithographic printing plate material was thus prepared.

| [Photosensitive liquid] | By wt. |
|---|---|
| Diallyl orthophthalate prepolmer | 90 parts |
| Pentaerythritol tetraacrylate | 69 parts |
| 2-(p-methoxystyryl)4,6-bis(triphloromethyl)-3-triazine | 5.5 parts |
| Polyvinyl pyrrolidone (Moisture sorption ratio: 45 - 48%) | 41 parts |
| Cellulose acetate butylate | 3 parts |
| Polyurethane resin (Moisture sorption ratio: 3%) | 18 parts |
| Fluoroborate salt of paraformaldehyde condensate of paradiazodiphenylamine | 16.5 parts |
| Copper phthalocyanine pigment (The same as in Example 1) | 30 parts |
| Dimethyl formamide/methyl ethyl ketone/methyl cellosolve (2:5:7) | 1120 parts |

The amount of photosensitive layer coated after drying was 15 $mg/dm^2$ by weight.

In a similar manner to that in Example 1, a printing plate was prepared after exposure to light and development; when it was set in a printing machine, a number

of prints with rich ink density were obtained.

Separately, as in Example 2, a lithographic printing plate material that had been coated and dried was kept for ten days at 55°C and at a relative humidity of 3 - 4%, and then exposure to light and development were successively carried out; it was found that the developability of the unexposed areas was inferior and that scumming was caused in the printing operation. Consequently, it is apparent that the plate of Example 2 i.e. an embodiment of the invention, is superior in preservability.

EXAMPLE 3

Coating and drying were carried out using the photosensitive liquid of the following composition, in a similar manner to that used in Example 1:

| [Photosensitive liquid] | By wt |
|---|---|
| Copolymer of styrene: hydroxyethyl methacrylate: butylacrylate: acrylic acid (25:40:25:10) (Moisture sorption ratio: 8%) | 70 parts |
| Resin in which p-octylphenol is condensed with formaldehyde | 10 parts |
| Oil-soluble diazo resin (The same as in Example 1) | 10 parts |
| Copper phthalocyanine pigment (The same as in Example 1) | 100 parts |
| Methyl cellosolve | 810 parts |

As in the case of Example 1, a negative film was brought into close contact therewith and the whole exposed to light. After being dipped in water at a temperature of 18°C, the non-image areas were removed by rubbing softly for one minute with absorbent cotton. Excellent prints were obtained of the original from the plate with fidelity and without any scumming.

## CLAIMS

1. A water-developable lithographic printing plate material comprising a support characterised by comprising on the support a photosensitive layer containing an oil-soluble diazo resin and a non-photosensitive resin having a moisture sorption ratio from 5 to 20% at 80% relative humidity.

2. A water-developable lithographic printing plate according to claim 1, wherein said oil-soluble diazo resin is a condensate of an aromatic diazonium salt and an active carbonyl-containing compound.

3. A water-developable lithographic printing plate material according to claim 2, wherein said active carbonyl containing compound is formaldehyde.

4. A water-developable lithographic printing plate material according to any one of claims 1 to 3, wherein said non-photosensitive resin is [A] a cellulose derivative or a polyvinyl alcohol derivative, [B] a homo- or copolymer of acrylic acid or methacrylic acid or [C] a homo- or copolymer of an acrylamide, a methacrylamide, an acrylic ester having a hydroxyl group,

or a methacrylic ester having a hydroxyl group.

5. A water-developable lithographic printing plate material according to claim 4, wherein said acrylamide, methacrylamide, acrylic ester or methacrylic ester is represented by the formula:

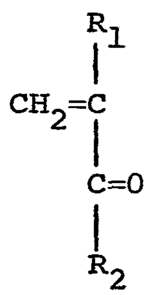

wherein $R_1$ is a hydrogen atom or a methyl group and $R_2$ is 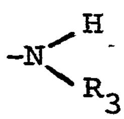 group or $-OR_4$ group (wherein $R_3$ is a hydrogen atom or 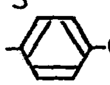OH group and $R_4$ is $-(CH_2)_m-$ OH group or $-(CH_2CH_2O)_n-$H group and m and n are independently an integer from 1 to 8).

6. A water-developable lithographic printing plate material according to any one of the preceding claims in which the photosensitive layer contains a filler.

7. A water-developable lithographic printing plate material according to claim 6 in which the filler has a particle size from 1 mμ to 10 μ.

8. A water-developable lithographic printing plate material according to any one of the preceding claims in which the photosensitive layer is directly on the support.

0068902

European Patent Office

# EUROPEAN SEARCH REPORT

Application number

EP 82303438.4

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| A | GB - A - 1 431 604 (NIPPON PAINT CO)<br>* Totality *<br>---- | | G 03 F 7/08 |
| | | | TECHNICAL FIELDS SEARCHED (Int.Cl. 3) |
| | | | G 03 F |
| | | | CATEGORY OF CITED DOCUMENTS<br>X: particularly relevant if taken alone<br>Y: particularly relevant if combined with another document of the same category<br>A: technological background<br>O: non-written disclosure<br>P: intermediate document<br>T: theory or principle underlying the invention<br>E: earlier patent document, but published on, or after the filing date<br>D: document cited in the application<br>L: document cited for other reasons |
| X | The present search report has been drawn up for all claims | | &: member of the same patent family, corresponding document |

| Place of search | Date of completion of the search | Examiner |
|---|---|---|
| VIENNA | 07-10-1982 | SALTEN |

EPO Form 1503.1 06.78